(19) **Europäisches Patentamt / European Patent Office / Office européen des brevets**

(11) **EP 4 521 300 A1**

(12) **EUROPEAN PATENT APPLICATION**

(43) Date of publication:
**12.03.2025 Bulletin 2025/11**

(21) Application number: **24198874.0**

(22) Date of filing: **06.09.2024**

(51) International Patent Classification (IPC):
**G06N 3/086** (2023.01)      **G06N 3/092** (2023.01)

(52) Cooperative Patent Classification (CPC):
**G06N 3/086; G06N 3/092**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.09.2023 KR 20230119976**

(71) Applicant: **Samsung Electronics Co., Ltd**
**Suwon-si, Gyeonggi-do 16677 (KR)**

(72) Inventors:
• **OH, Youngmin**
  **16678 Suwon-si (KR)**
• **KWON, Hyung-Dal**
  **16678 Suwon-si (KR)**
• **HWANG, Bosun**
  **16678 Suwon-si (KR)**

(74) Representative: **Arnold & Siedsma**
**Bezuidenhoutseweg 57**
**2594 AC The Hague (NL)**

(54) **METHOD FOR PERFORMING GENETIC OPTIMIZATION AND A CIRCUIT DESIGN METHOD USING THE SAME**

(57)     A method for performing a genetic algorithm to solve an optimization problem is disclosed. The method for performing a genetic algorithm is performed by one or more processors, and the method comprises: generating, by using a neural network, a subset of elements from a population comprising elements that each correspond to a respective possible solution to the problem; generating child elements of the elements of the subset by performing a genetic algorithm on the subset; and determining that one of the child elements, from among said child elements, is an answer to the problem.

FIG. 2

Start

Generating population — S110

Generating subset of population — S120

Performing GA process using element selected from subset — S130

Calculating fitness value by performing simulation on K child elements generated through GA process — S140

Whether fitness value of child element satisfies predetermined criteria? — S150

No

S160 — Updating population based on fitness value of child element

Yes

Determining child element that meets predetermined criteria as answer to problem — S170

End

EP 4 521 300 A1

**Description**

BACKGROUND

1. Field

The present disclosure relates to a method for performing a genetic algorithm to solve an optimization problem, a method of designing an electronic device using the genetic algorithm and a method for generating a subset of a population for a genetic algorithm.

2. Description of Related Art

Genetic algorithms are computational models analogous to an evolutionary process of the natural world and is one of various global optimization techniques used to solve optimization problems. A genetic algorithm is generally an in-parallel global search algorithm mimicking the selectivity of biological genetics in the natural world and may generate superior solutions to an optimization problem. Generally, the problem is solved by forming possible/proposed solutions to the optimization problem into a fixed structure and modifying the possible solutions little by little, testing whether the modifications move the proposed solutions closer to a solution. In other words, a genetic algorithm may simulate an evolution to find a solution x that optimizes some unknown function $Y = f(x)$.

SUMMARY

A method may perform a genetic algorithm to solve problems.

A method may design an electronic device through a genetic algorithm.

A method may generate a subset of a population to be used in a genetic algorithm.

In one general aspect, a method for performing a genetic algorithm is performed by one or more processors, and the method comprises: generating a subset of elements by using a neural network from a population comprising elements that each correspond to a respective solution to a problem; generating child elements by performing a genetic algorithm on the subset; and determining that one of the child elements, from among the child elements is an answer to the problem.

The subset may be generated based on scores of the elements output from the neural network, the scores comprising, or corresponding to, probabilities of the elements.

The generating of the subset based on the scores of the elements output from the neural network may comprise sampling an element with the score greater than a predetermined magnitude.

The generating of the subset based on the scores of the elements output from the neural network may comprise sampling a predetermined number of the elements in order of the largest score to smallest score.

The generating of the child elements by performing the genetic algorithm on the subset may comprise: selecting two elements from the subset; and applying a genetic operator to the selected elements to generate one of the child elements.

The genetic operator may comprise a crossover operator, a mutation operator, or a local optimization operator.

The determining of the one of the child elements that is the answer may comprise: determining fitness values by performing a simulation on the problem for the respective child elements; and providing a reward to the neural network based on the fitness values of the child elements.

The providing of the reward to the neural network based on the fitness values of the child elements may comprise: updating the neural network based on a difference between a fitness value of the elements in the population and a fitness value of the child elements.

The determining of the one of the child elements that is the answer may further comprise updating the elements in the population based on the fitness values of the child elements.

The updating of the elements in the population based on the fitness values of the child elements may comprise replacing an element in the population with a child element determined to have a fitness value greater than fitness values of the elements in the population.

The determining of the one of the child elements that is the answer may comprise determining a child element among the child elements that has a fitness value that satisfies predetermined criteria among the fitness values of the child elements as the one of the child elements that is the answer.

Each of the elements may be generated by encoding an order of blocks to be placed in a peripheral area of a memory.

The method may further comprise: in response to determining that there is no answer among the child elements, generating a new subset of elements; generating new child elements by performing the genetic algorithm for the newly generated subset; and searching for the answer among the newly generated elements.

**EP 4 521 300 A1**

In another general aspect, a method for designing an electronic device comprises: generating a subset comprising elements by performing a sampling using a neural network on elements each corresponding to a different ordering of blocks that are to be arranged in a predetermined area of the electronic device; performing a genetic algorithm by using the subset to generate child elements of the elements; and determining an ordering of the blocks to be arranged in the predetermined area by selecting one of the child elements obtained through the genetic algorithm, the selected child element indicating the ordering of the blocks.

The generating of the subset by performing the sampling using the neural network on the elements may comprise: determining a probability of an element in a population generated from a random selection of the elements, the probability determined using the neural network; and generating the subset based on the probability.

The probability may correspond to a possibility that a child element generated from the element in the subset is determined to be an optimal solution of a problem being solved by the genetic algorithm.

The generating of the subset based on the probability may comprise sampling an element with a probability greater than a predetermined magnitude or sampling a predetermined number of elements in order of the higher probability.

The method may further comprise: after the performing of the genetic algorithm using the subset, updating the neural network based on a fitness value of a child element obtained from the subset through the genetic algorithm.

In yet another general aspect, a method for generating a subset of a population for a genetic algorithm is performed by one or more processors and comprises: determining scores of respective elements comprised in the population by using a neural network to infer the scores; generating the subset comprising elements in the population based on the scores; and updating the neural network based on a fitness value of a child element generated from the elements in the subset.

The updating of the neural network based on the fitness value of the child element generated may comprise: determining the fitness value of the child element for a problem to which the genetic algorithm is applied by performing a simulation on the child element; and providing a reward to the neural network based on the fitness value of the child element.

In a further general aspect, there is provided a method according to any one of the following clauses:

1. A method for performing a genetic algorithm performed by one or more processors, the method comprising:

generating a subset of elements by using a neural network from a population including elements that each correspond to a respective solution to a problem;
generating child elements by performing the genetic algorithm on the subset; and
determining that one of the child elements, from among the child elements is an answer to the problem.

2. The method of clause 1, wherein the subset is generated based on scores of the elements output from the neural network, the scores comprising, or corresponding to, probabilities of the elements.

3. The method of clause 1 or 2, wherein the generating of the subset based on the scores of the elements output from the neural network comprises
sampling an element with the score greater than a predetermined magnitude.

4. The method of clause 1 or 2, wherein the generating of the subset based on the scores of the elements output from the neural network comprises
sampling a predetermined number of the elements in order of the largest score to smallest score.

5. The method of clause 1, wherein the generating of the child elements by performing the genetic algorithm on the subset comprises:

selecting two elements from the subset; and
applying a genetic operator to the selected elements to generate one of the child elements.

6. The method of clause 5, wherein the genetic operator includes a crossover operator, a mutation operator, or a local optimization operator.

7. The method of any one of the preceding clauses, wherein the determining of that the one of the child elements is the answer comprises:

determining fitness values of the child elements by performing a simulation on the problem for the respective child elements; and
providing a reward to the neural network based on the fitness values of the child elements.

8. The method of clause 7, wherein the providing of the reward to the neural network based on the fitness values of the child elements comprises:
updating the neural network based on a difference between a fitness value of the elements in the population and a fitness value of the child elements.

9. The method of clause 7 or 8, wherein determining the one of the child elements is the answer further comprises updating the elements in the population based on the fitness values of the child elements.

10. The method of clause 9, wherein the updating of the elements in the population based on the fitness values of the child elements comprises

replacing an element in the population with a child element determined to have a fitness value greater than fitness values of the elements in the population.

11. The method of any one of clauses 7 - 10, wherein the determining of that the one of the child elements is the answer further comprises

determining one having a fitness value that satisfies a predetermined criteria among the child elements as the answer.

12. The method of any one of the preceding clauses, wherein each of the elements is generated by encoding an order of blocks to be placed in a peripheral area of a memory.

13. The method of any one of the preceding clauses, further comprising:

    in response to determining that there is no answer among the child elements,
    generating a new subset of elements;
    generating a new child elements by performing the genetic algorithm for the newly generated subset; and
    searching for the answer in the newly generated child elements.

14. A method for designing an electronic device, the method comprising:

    generating a subset including elements by performing a sampling using a neural network on elements each corresponding to a different ordering of blocks that are to be arranged in a predetermined area of the electronic device;
    performing a genetic algorithm by using the subset to generate child elements of the elements; and
    determining an ordering of the blocks to be arranged in the predetermined area by selecting one of the child elements obtained through the genetic algorithm, the selected child element indicating the ordering of the blocks.

15. The method of clause 14, wherein the generating of the subset by performing the sampling using the neural network on the elements comprises:

    determining a probability of an element in a population generated from a random selection of the elements, the probability determined using the neural network; and
    generating the subset based on the probability.

16. The method of clause 15, wherein:
the probability corresponds to a possibility that a child element generated from the element in the subset is determined to be an optimal solution of a problem being solved by the genetic algorithm.

17. The method of clause 15 or 16, wherein the generating of the subset based on the probability includes sampling an element with a probability greater than a predetermined magnitude or sampling a predetermined number of elements in order of the highest probability to lowest probability.

18. The method of any one of clauses 15-17, further comprising:

    after the performing of the genetic algorithm using the subset,
    updating the neural network based on a fitness value of a child element obtained from the subset through the genetic algorithm.

19. A method for generating a subset of a population for a genetic algorithm, the method performed by one or more processors, the method comprising:

    determining scores of respective elements included in the population by using a neural network to infer the scores;
    generating the subset including to include elements of the elements in the population based on the scores; and
    updating the neural network based on a fitness value of a child element generated from the elements in the subset.

20. The method of clause 19, wherein the updating of the neural network based on the fitness value of the child element generated comprises:
determining the fitness value of the child element for a problem to which the genetic algorithm is applied by performing a simulation on the child element; and providing a reward to the neural network based on the fitness value of the child element.

Other features and aspects will be apparent from the following detailed description, and the drawings.

BRIEF DESCRIPTION OF THE DRAWINGS

FIG. 1 illustrates a problem solving system according to one or more embodiments.
FIG. 2 illustrates a problem solving method using a genetic algorithm according to one or more embodiments.
FIG. 3 illustrates a reinforcement learning method of a subset generator according to one or more embodiments.
FIG. 4 illustrates a reinforcement learning method of a subset generator according to one or more embodiments.
FIG. 5 illustrates a GA process according to one or more embodiments.
FIG. 6 illustrates a neural network according to one or more embodiments.
FIG. 7 illustrates a problem-solving system according to one or more embodiments.
FIG. 8 illustrates a problem solving method according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to comprise the plural forms as well, unless the context clearly indicates otherwise. As used herein, the term "and/or" comprises any one and any combination of any two or more of the associated listed items. As nonlimiting examples, terms "comprise" or "comprises," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may comprise or implement, means that at least one example or embodiment exists where such a feature is comprised or implemented, while all examples are not limited thereto.

An artificial intelligence model (AI model) running a neural network according to the present disclosure is a machine learning model that learns at least one task, and may be implemented as a computer program (instructions) executed by a processor. The task learned may be a task to be solved through machine learning or a task to be performed through the machine learning. The AI models may be implemented as computer programs (instructions) running on computing devices, downloaded over a network, or rendered in a product form. Alternatively, the artificial intelligence model may be linked to various devices through a network.

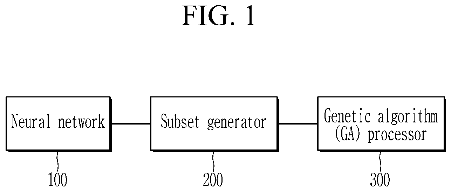

FIG. 1 illustrates a problem-solving system according to one or more embodiments.

A problem-solving system may comprise a neural network 100, a subset generator 200, and a genetic algorithm (GA) processor 300. The problem-solving system may perform a genetic algorithm by using the neural network 100, the subset generator 200, and the GA processor 300 to derive a solution to a specific problem. The GA processor 300 may output a predetermined number (K) of solutions for each step (iteration/generation) of the genetic algorithm.

The problem-solving system may verify whether any of the output K solutions may be the optimal solution to the specific problem through a simulation. If any one solution among the K output solutions meets a predetermined criteria, then the problem-solving system may determine that that solution (the solution that satisfies the predetermined criteria) is the solution to the given problem.

Preferably, the genetic algorithm may be a computational model mimicking an evolutionary phenomenon of the natural world and may determine better solutions by expressing possible solutions (to the problem to be solved) in a predetermined data structure and by iteratively modifying the solutions. A given solution may be encoded and generated as one element, and multiple elements (e.g., multiple elements selected randomly) may be comprised in a population, the population being a set of the solutions that changes from generation to generation. That is to say, the solutions comprised in a population may be updated when each step (iteration, new generation, etc.) of the genetic algorithm is completed.

Preferably, the neural network 100 may perform an inference on an element in a population, and may output the inference as a score or a probability of the element comprised in a population (hereafter, "probability" refers to "score or probability", as a score will generally be derived from, or correspond to, a probability). The probability of an element may indicate the possibility that the element will generate (e.g., parent, mutate to, etc.) a child element that may ultimately be determined to be the solution to the problem. In other words, the probability of an element may be the likelihood that a child (next generation) element generated based thereon will be the solution to the problem. In other words, the probability of an element may indicate the possibility that a child element generated from that element will be determined to be the answer to the problem.

Whether the child element will be the answer to the problem may be determined according to a fitness value calculated from a simulation performed on the child element. When the fitness value of the child element meets a predetermined criteria (e.g., exceeds a predetermined reference value), the child element may be determined to be the answer to the problem (as used herein "the answer" and "the solution" do not imply that such answer/solution is the best or only answer/solution, rather this refers to the answer/solution having been determined to be an optimum/sufficient answer/solution according to the performed process).

Preferably, the neural network 100 may perform reinforcement learning. An agent (employing the neural network 100) may be configured to determine the probabilities of the respective elements in the population as an action. The agent may output the probabilities of the respective elements in the population as the action based on a policy (the population functioning as an environment corresponding to the agent). Since the probability of each element is a basis for generating the subset (or a sub-population) of the population, the population may be updated (changing the state of the environment) according to the fitness value of the child element generated from the element selected in the subset by the genetic algorithm and a reward may be given to the agent (which is operated by the neural network 100). For example, the reward may correspond to the difference between a maximum fitness value of the elements (among the values of the elements) in the population and a maximum fitness value of the child elements generated from the selected elements in the subset.

Preferably, the neural network 100 may be updated by changing the policy according to the fitness value of the child element (a policy gradient). In the policy gradient, the policy to be applied to the neural network 100 (or to the agent) may be changed to maximize the expected reward and the gradient of the policy may be inferred.

Preferably, the neural network 100 may comprise at least one of a transformer (e.g., Bilinear transformer), a recurrent neural network (RNN), a long short term memory (LSTM), and/or a permutation-equivariant fully connected network that process a large-scale input such as a population.

Preferably, the subset generator 200 may generate a subset (e.g., a next generation population) of the population based on the probability output from the neural network 100. The subset generator 200 may generate the subset from the current population by selecting, from the current population, the elements having respective probabilities greater than a predetermined magnitude. Alternatively, the subset generator 200 may generate the subset from the population by sequentially sampling/selecting a predetermined number of the elements in order of their probabilities, from high to low (i.e., selecting the top-N elements in terms of probabilities).

Preferably, the GA processor 300 may select a pair of elements (parent elements) from the subset generated by the subset generator 200 to (i) perform the genetic algorithm (form a child element) and (ii) perform the simulation (related to the problem) for the child element generated through the genetic algorithm, thereby determining the answer to the given problem. For example, the GA processor 300 may determine at least one child element with the fitness value that satisfies the predetermined criteria among the K child elements (obtained by performing the genetic algorithm) as the answer to the problem to be solved.

As above-described, the problem-solving system according to some embodiments may perform the calculation of the probabilities of elements in the population by using the neural network 100 and perform the generation of the subset and the GA process by using the subset generator 200 and the GA processor 300, thereby the workload of the genetic algorithm may be distributed between the processor (e.g., GPU) corresponding to (executing) the neural network 100 and the processor (e.g., CPU) corresponding to the subset generator 200 and the GA processor 300. Alternatively, the part that may use the in-parallel operation among the operations of the GA processor may be performed by the processor corresponding to the neural network 100. Additionally, by using the subset in the GA process, a search space may be reduced compared to the population, so the operation results of the GA process itself may be output quickly.

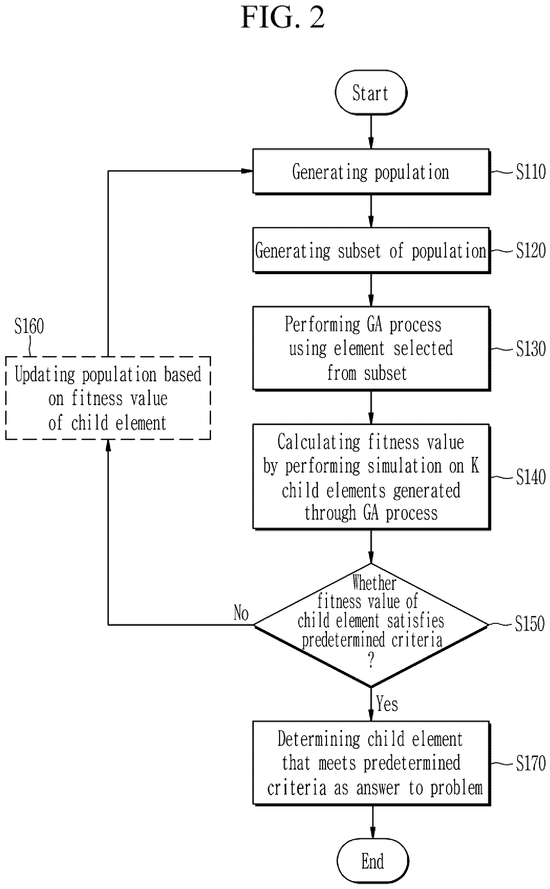

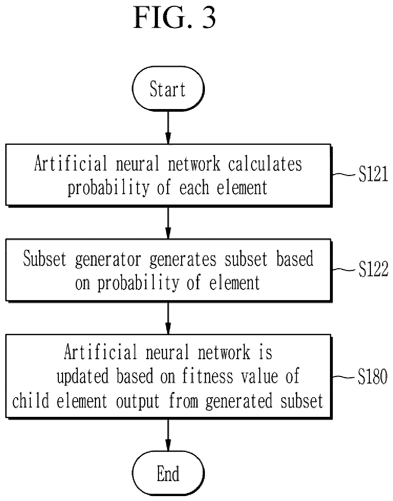

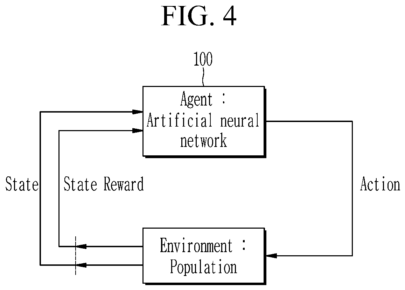

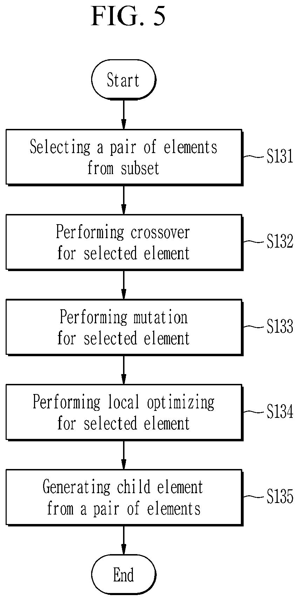

FIG. 2 illustrates a problem-solving method using a genetic algorithm according to one or more embodiments. FIG. 3 illustrates a reinforcement learning method of a subset generator according one or more some embodiments. FIG. 4 illustrates a reinforcement learning method of a subset generator according to one or more embodiments. FIG. 5 illustrates a GA process according to one or more embodiments.

Referring to FIG. 2, a population comprising multiple elements may be generated through a population initialization (5110). When n genes are comprised in one element, the number of all elements (possible solutions) related to a given problem may be n! (n factorial).

Through the population initialization, a predetermined number of elements among the n! elements may be comprised in the initial population. The number of the elements comprised in the population may be set according to a type of the problems.

Preferably, the problem that the problem-solving system seeks to solve using the genetic algorithm may be an arrangement of blocks responsible for a predetermined function in predetermined areas of an electronic device when the electronic device is designed. For example, the problem may be to arrange a set of blocks in a line in a peripheral area of the electronic device (for example, but not limited to a memory circuit/device). In other words, the problem is modeled as an order of blocks for together controlling an operation of the memory device (e.g., electronic components consisting of the controller), where the blocks are placed in the peripheral area of the memory. In this example, the genetic algorithm may be used to minimize a length of wires respectively connecting components.

Preferably, a set of blocks needs to be placed in one linear dimension within the peripheral area of the memory, the order of the blocks for that arrangement may be encoded as a numeric string or a vector. At this time, the encoded numeric string or vector may each correspond to one element. For example, in a problem of arranging six blocks with identifiers of 0 to 5, respectively, an order of the blocks may be an element that is encoded as a numeric string or the vector such as [0,1,2,3,4,5].

Preferably, all elements in the initial population may be assigned with an arbitrary (e.g., random) fitness value. The same or different fitness values may be given to two different elements.

Preferably, the elements comprised in the population may be generated using a breadth first search (BFS) method and/or a depth first search (DFS) method with each node (one node corresponds to one block) of a graph as a root node. The number of the elements generated by the DFS method and/or BFS method may be the same as the number of the blocks to be placed in the peripheral area.

The generated population may be input to the neural network 100, and the neural network 100 may output the probabilities of the respective elements comprised in the population. The probability of an element may indicate the possibility that a child element generated from that element in the subset will be determined as the answer to the problem or the possibility that the element in the subset generates the child element that will be determined as the answer to the problem.

Referring to FIG. 3, the neural network 100 may be an agent of the reinforcement learning and may take an action to output the probabilities of the elements in the environment (population). Afterwards, each element may be sampled as the subset according to the probability of the element, the reward may be given to the neural network 100 according to the fitness value of, for example, the child element generated from the pair of elements selected in the subset, and the neural network 100 may be updated using the policy gradient of the reward.

Referring to FIG. 2, the subset generator 200 may generate the subset of the population based on the probabilities of the elements within the population (S120). Preferably, the subset generator 200 may generate the subset by sampling a predetermined number of the elements in order of probabilities of each element. The subset generator 200 may sample a predetermined number of elements (e.g., starting from the largest probability). Alternatively, the subset generator 200 may generate the subset by sampling the elements whose probabilities are greater than a Bernoulli probability of a predetermined magnitude (a Bernoulli sampling). In other words, the subset generator 200 may compare the probability of each element with the Bernoulli probability and sample the elements with the score or probability greater than the Bernoulli probability.

With the Bernoulli sampling technique, a reference value may be determined in advance depending on the number of the elements to be comprised in the subset. For example, when the subset needs to comprise about 100 elements, the subset generator 200 may determine the reference value so that about 100 elements may be sampled. The number of the elements comprised in the subset may be a hyperparameter.

Preferably, the subset generator 200 may generate the subset based on the probabilities of the respective elements inferred from, and output by the neural network 100 (e.g., RNN, LSTM, GRU, etc.), which may be trained through the reinforcement learning. The reward of the reinforcement learning may be determined based on the fitness value of the child elements generated from the elements selected into the subset.

Referring to FIG. 4, the neural network 100 may output the probabilities of the respective elements of the population (S121), and the subset generator 200 may generate the subset by sampling the elements in the population based on their corresponding probabilities (S122). Preferably, the subset generator 200 may sample the elements comprised in the population in order of the magnitude of the probabilities of the elements or sample the elements with the probability greater than a predetermined magnitude. The probability of the element may indicate the possibility that a child element generated from the element in the subset is determined as the answer or the possibility that the elements within the subset generates the child elements to be determined as the answer.

Referring to FIG. 2, the GA processor 300 may generate the child elements by performing the GA process using several pairs of elements selected from the subset (S130). The GA processor 300 may generate the child elements by applying at least one genetic operator to each pair of elements (e.g., deriving a child based on inclusion of parts of the parent elements). Preferably, the GA processor 300 may select K pairs of elements and generate the K child elements from the K pairs of elements. Preferably, one or more child elements may be generated directly from an element in the subset, e.g., by permuting an element to form a child element.

Referring to FIG. 5, the GA processor 300 may select a pair of elements from the subset by using an algorithm such as a roulette wheel selection (S131). Additionally, the GA processor 300 may generate a child element by applying at least one genetic operator to the selected element(s). The genetic operator may be, for example, a crossover operator (S132, e.g., forming a child from two parents), a mutation operator (S133, e.g., mutating an element in the subset, the mutated element being the child element), and/or a local optimization operator (S134), as nonlimiting examples. Then, the GA processor 300 may generate/output the child element from the element pair (or single element) derived by the at least one genetic operator (S135).

The crossover operator may perform for an ordered crossover on the genes within the elements in a pair, such as a partially matched crossover (PMX), which is applied to permutation problems.

The mutation operator may randomly assign a value between 0 and 1 to each gene of an element being mutated and perform a swap between the genes whose assigned value is less than a threshold.

The local optimization operator may shift each gene of an element. For example, the local optimization operator may shift the gene of [0,1,2,3,4,5] and transform the element into [1,2,3,4,5,0].

Referring to FIG. 2, the GA processor 300 may calculate the fitness values of the child elements by performing the simulation on the problem to be solved for the K child elements generated through the GA process (S140).

In the circuit design example described above, the fitness value of a child element (which has been generated through the genetic algorithm) may correspond to the length of the wire formed by the block to be placed in the peripheral area. For example, a child element with a relatively large fitness value may indicate that the order of the arrangement of the block (for that child element) makes the total length of the wires relatively short. Alternatively, a child element with a relatively small fitness value may indicate the order of the arrangement of the block (for that child element) makes the total length of the wires relatively long.

Afterwards, the GA processor 300 may determine whether the fitness values of any of the child elements satisfy the predetermined criteria (S150).

Preferably, when no child elements satisfy the predetermined criteria, the neural network 100 and the subset generator 200 may generate a new subset from the population. The GA processor 300 may generate the child elements from the new subset by performing the genetic algorithm on the elements and/or element pairs selected from the new subset. Preferably, it is a step in the genetic algorithm from the generation of the subset to the generation and evaluation of the predetermined number (K) of child elements. In other words, when the answer is not determined from any of the child elements generated by one step of the genetic algorithm, the GA processor 300 may generate a new subset and perform the next step (e.g., the step of generating the new child elements and the step of searching for the answer to the problem in the new child elements) of the genetic algorithm.

Referring to FIG. 2, after the GA processor 300 performs one step of the genetic algorithm, it may update the elements of the population based on the fitness values of the child elements (S160). The GA processor 300 may replace element having fitness values that are smaller than the fitness value of the child element generated from the subset from the population used for the generation of the subset. For example, when the fitness value of a child element is greater than the fitness value of any element in the population, the GA processor 300 may replace that element in the population with the corresponding child element. In other words, elements with greater fitness values may be newly comprised in the population, and the newly comprised elements may be sampled (from among the population) into the subset in the next step of the genetic algorithm.

Meanwhile, when the GA processor 300 performs the genetic algorithm by a predetermined number of times, the cumulative reward determined based on the fitness value of the child element may be provided to the neural network. Referring to FIG. 4, the neural network 100 may be updated by changing the policy to maximize the cumulative reward (S180). In other words, the neural network 100 may be updated by changing the policy to maximize the fitness values of the child elements generated through the genetic algorithm. The cumulative reward according to the reinforcement learning may be described by a value function Q as shown in Equation 1 below.

Equation 1

$$Q^{\pi}(s_t, a_t) := \mathbb{E}_{\substack{s_{t+1:\infty}, \\ a_{t+1:\infty}}} \left[ \sum_{l=0}^{\infty} r_{t+l} \right]$$

In Equation 1, $a_t$ represents an action of the neural network (the agent) at a time step t, $s_t$ represents a state of the population (an environment) at the time step t, and $Q^{\pi}(s_t, a_t)$ represents a value function regarding the action of the agent taken on the state of the environment at the time step t.

$$\sum_{l=0}^{\infty} r_{t+l}$$

As shown in Equation 1, the sum of the rewards after the time step t may be provided to the agent.

Although mathematical notation is used above, it will be appreciated that the mathematical notation is shorthand describing operations that could be described with English words, but such textual description would be difficult to understand. The mathematical notation and equations above may be readily translated into source code that can be compiled to produce processor-executable instructions that when executed cause the processor(s) to operate as described by the mathematical notation.

Preferably, the reward provided to the agent may be determined based on a difference between the fitness values of the child elements at the previous step and the current step of the genetic algorithm. Preferably, the reward may be determined based on a difference between a fitness value of the elements in the population and a fitness value of the child elements, to update the neural network 100. For example, the reward may be determined based on a difference between the maximum fitness value of the child element generated in the current step and the maximum fitness value of the element in the population of the current step of the genetic algorithm. Alternatively, the reward may be determined based on a difference between the maximum fitness value of the element in the population of the current step and the maximum fitness value of the element in the population of the previous step. The reward may be determined at every step of the genetic algorithm, and then the accumulated reward may be provided to the neural network 100 while the genetic algorithm is performed a predetermined number of times (or until a solution element is found).

Preferably, the policy of the neural network 100 may be updated to minimize the length of the wires formed by the block to be placed in the peripheral area. Here, changing the policy to maximize the fitness value of the child element may correspond to changing the policy to minimize the length of the wires formed by block.

Referring to FIG. 2, the GA processor 300 may terminate the genetic algorithm by determining a child element that meets a predetermined criteria as the answer to the problem (S170).

As explained above, the problem-solving system according to some embodiments may perform an adaptive sampling to sample an element (or element pair) that generates a child element close to the solution to the problem by using the neural network and the subset generator, thus improving the performance of the genetic algorithm solving the problem. In other words, by adaptively sampling the element corresponding to the solution of the problem by using the neural network and the subset generator, the speed of the genetic algorithm may be improved and the answer to the problem may be accurately derived.

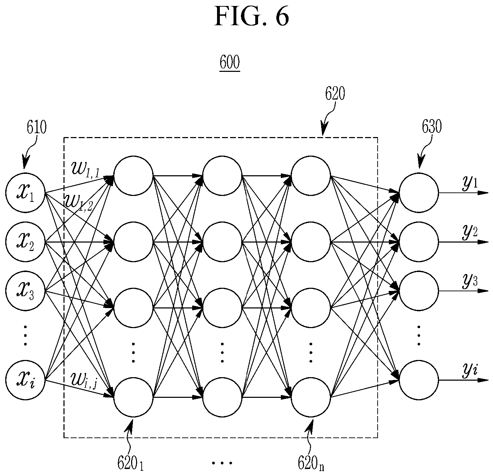

FIG. 6 illustrates a neural network, according to one or more embodiments.

Referring to FIG. 6, a neural network 600 according to some embodiments may comprise an input layer 610, one or more hidden layers 620, and an output layer 630. The input layer 610, the hidden layer(s) 620, and the output layer 630 each comprise a respective set of nodes connected to the nodes of an adjacent layer. Strengths of connections between the nodes may correspond to weight values (weighted connections) (e.g., $w_{1,1}$ to $w_{i,j}$, wherein i and j may be a positive integer). The nodes comprised in the input layer 610, the hidden layer 620, and the output layer 630 may be connected to each other in a fully connected manner, however, any suitable neural network architecture may be used. Preferably, a number of parameters (e.g., the number of weight values or the number of bias values) may be equal to the number of inter-node connections in the neural network 600.

The input layer 610 may comprise input nodes ($x_1$ to $x_i$), and the number of the input nodes ($x_1$ to $x_i$) may correspond to the number of independent variables. For training of the neural network 600, a training dataset may be input to the input layer 610. When the test data set is input to the input layer 610 of the trained neural network 600, an inference result may be output from the output layer 630 of the trained neural network 600. Preferably, the input layer 610 may have a structure suitable for processing a large-scale input.

The hidden layer 620 may be positioned between the input layer 610 and the output layer 630 and may comprise hidden layers $620_1$ to $620_n$. The output layer 630 may comprise at least one output node $y_1$ to $y_j$. An activation function may be used in the hidden layers 620 and the output layer 630. Preferably, the neural network 600 may be learned by adjusting the weights of the nodes comprised in the hidden layers 620.

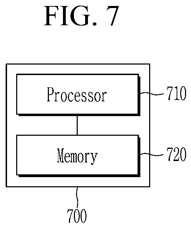

FIG. 7 illustrates a problem-solving system, according to one or more embodiments.

A problem-solving system according to some embodiments may be implemented as a computer system, for example, a computer-readable medium. Referring to FIG. 7, a computer system 700 may comprise at least one processor 710 and a memory 720. The memory 720 may be connected to the processor 710 and store various information for driving the processor 710 or at least one program executed by the processor 710. The memory 720 may also store instructions configured to cause the processor perform processes of the above described method. Although processor 710 is referred to in the singular, the processor 710 may in practice be implemented as a single processor (e.g., a CPU) or a combination of processors (e.g., one or more CPUs and one or more GPUs).

The processor 710 may implement the function, process, or method proposed in some embodiments. The operation of the computer system 700 according to some embodiments may be implemented by the processor 710. At least one processor 710 may comprise both GPU and CPU.

In some embodiments of this description, the memory 720 may be positioned inside or outside the processor, and the memory may be connected to the processor through various known means. The memory may be a volatile or non-volatile storage media of various forms, and for example, the memory may comprise a read-only memory (ROM) or a random access memory (RAM).

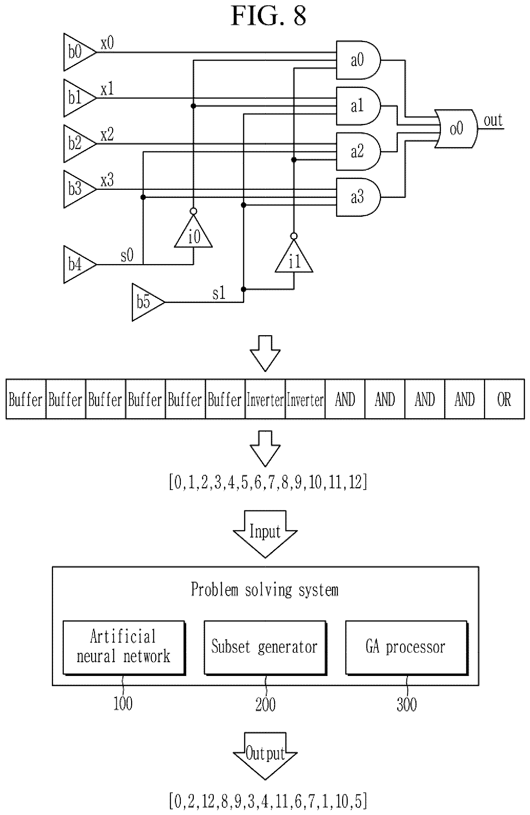

FIG. 8 illustrates a problem-solving method, according to one or more embodiments.

Preferably, to optimize one-dimensional arrangement of blocks (e.g., a buffer, an inverter, an AND gate, and an OR gate, etc.) in a peripheral area of memory semiconductors (DRAM, FLASH, SSD, CIS, DDI, SoC, Smart Card, MCU, etc.), the problem-solving system described herein may be used.

Referring to FIG. 8, when six buffers (e.g., buffers b0 to b5), two inverters (e.g., inverters i0 and i1), four AND gates (e.g., AND gates a0 to a3), and one OR gate (e.g., OR gate o0) are arranged in the peripheral area of the memory, the order of the arrangement of each block may be encoded as a numeric string or a vector as shown in Equation 2 below. In an embodiment, data x0 to x3, s0 and s1 may be output from the buffers b0 to b5, respectively, and data out may be output from the OR gate o0.

$$\text{Equation 2}$$
$$[0,1,2,3,4,5,6,7,8,9,10,11,12]$$

When the numeric string or the vector related to the order of the arrangement of the blocks is input to the problem-solving system, the problem-solving system may generate a population related to the order of the arrangement of the block and output the solution to the problem by using the genetic algorithm within the generated population.

In this description, the neural network 100 may operate as an agent of a reinforcement learning network to output the score or probability of each element comprised in the population.

The subset generator 200 may generate a subset of the population based on the score or probability of the element within the population.

The GA processor 300 may generate child elements from the element selected from the subset by performing the GA process.

Afterwards, based on fitness values calculated through the simulation of the child elements, at least one child element among the child elements generated by the GA processor 300 may be output as the answer to the problem. The child element, which is the answer to the problem, may indicate the order of the arrangement of the blocks that may minimize the total length of the wires connecting the blocks to be arranged in the peripheral area of the memory. The solution to the problem illustrated in FIG. 8 is the numeric string [0,2,12,8,9,3,4,11,6,7,1,10,5].

In this way, the problem-solving system according to some embodiments may quickly output the answer regarding the order of the arrangement of the blocks by generating the subset for performing the genetic algorithm based on the score or probability of the element calculated using the neural network. In addition, by adaptively sampling the element corresponding to the solution of the problem by using the neural network and the subset generators, the speed of the genetic algorithm to find the optimal order of the arrangement of the block may be improved and the best answer can be derived.

Meanwhile, the embodiments are not only implemented through the devices and/or methods described so far, but may be implemented through a program (instructions) that realizes functions corresponding to the configuration of the embodiments or a recording medium on which the program is recorded, and this implementation may be implemented by anyone skilled in the art from the description of the embodiments described above. Specifically, the method according to some embodiments (e.g., a method for performing genetic algorithm and a method for designing an electronic device, etc.) may be implemented in a form of a program instruction that can be executed through various computer means and recorded on a computer-readable medium. The computer-readable medium may comprise program instructions, data files, data structures, etc., singly or in combination. The program instructions recorded on the computer-readable medium may be specially designed and configured for the examples, or may be known and available to those skilled in the art of computer software. The computer-readable recording medium may comprise a hardware device configured to store and execute the program instructions. For example, a computer-readable recording medium comprises magnetic media such as hard disks, floppy disks and magnetic tapes, optical recording media such as CD-ROMs and DVDs, and optical disks such as floppy disks. It may be magneto-optical media, ROM, RAM, flash memory, or the like. A program instruction may comprise not only machine language code such as generated by a compiler, but also high-level language code that can be executed by a computer through an interpreter or the like.

The computing apparatuses, the electronic devices, the processors, the memories, the displays, the information output system and hardware, the storage devices, and other apparatuses, devices, units, modules, and components described herein with respect to FIGS. 1-8 are implemented by or representative of hardware components. Examples of hardware components that may be used to perform the operations described in this application where appropriate comprise controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer comprises, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may comprise multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which comprise a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-8 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software comprise machine code that is directly executed by the one or more processors or computers, such as machine code produced by a compiler. In another example, the instructions or software comprises higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium comprise read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card or a micro card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure comprises specific examples, it will be apparent after an understanding of the disclosure of this application that various changes in form and details may be made in these examples without departing from the scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the disclosure may also be defined by the claims and their equivalents, and all variations within the scope of the claims and their equivalents are to be construed as being comprised in the disclosure.

**Claims**

1. A method for performing a genetic algorithm performed by one or more processors to solve an optimization problem, the method comprising:

   generating, by using a neural network, a subset of elements from a population comprising elements that each correspond to a respective possible solution to the problem;
   generating child elements by performing the genetic algorithm on the subset; and
   determining that one of the child elements, from among said child elements, is an answer to the problem.

2. The method of claim 1, wherein the subset is generated based on scores of the elements output from the neural network, the scores comprising, or corresponding to, probabilities of the elements.

3. The method of claim 2, wherein the generating of the subset based on the scores of the elements output from the neural network comprises:
sampling or selecting an element with a score greater than a predetermined magnitude.

4. The method of claim 2 or 3, wherein the generating of the subset based on the scores of the elements output from the neural network further comprises:
sampling or selecting a predetermined number of the elements in order of their scores from largest score to smallest score.

5. The method of any one of the previous claims, wherein the generating of the child elements by performing the genetic algorithm on the subset comprises:

   selecting two elements from the subset; and
   applying a genetic operator to the selected elements to generate one of the child elements; wherein preferably the genetic operator comprises a crossover operator, a mutation operator, or a local optimization operator.

6. The method of any one of the previous claims, wherein the determining of the one of the child elements that is the answer to the problem comprises:

   determining fitness values of the child elements by performing a simulation on the problem for the respective child elements; and
   providing a reward to the neural network based on the fitness values of the child elements.

7. The method of the previous claim, wherein the providing of the reward to the neural network based on the fitness values of the child elements comprises:
updating the neural network based on a difference between a fitness value of the elements in the population and a fitness value of the child elements.

8. The method of claim 6 or 7, wherein the determining of the one of the child elements that is the answer to the problem further comprises:

   updating the elements in the population based on the fitness values of the child elements; wherein preferably the updating of the elements in the population based on the fitness values of the child elements comprises:
   replacing an element in the population with a child element determined to have a fitness value greater than fitness values of the elements in the population.

9. The method of any one of the previous claims, wherein the determining of the one of the child elements that is the answer to the problem further comprises:
determining a child element among the child elements that has a fitness value that satisfies predetermined criteria as the one of the child elements that is the answer to the problem; and/or wherein each of the elements is generated by encoding an order of blocks to be placed in a peripheral area of a memory.

10. The method of any one of the previous claims, further comprising:

    in response to determining that there is no answer among the child elements,
    generating a new subset of elements;
    generating new child elements by performing the genetic algorithm for the newly generated subset; and
    searching for the answer among the newly generated child elements.

11. A method for designing an electronic device, the method comprising:

    generating a subset comprising elements by performing sampling, using a neural network, on elements each corresponding to a different ordering of blocks that are to be arranged in a predetermined area of the electronic device;
    performing a genetic algorithm using the subset to generate child elements of the elements; and
    determining an ordering of the blocks to be arranged in the predetermined area by selecting one of the child elements obtained through the genetic algorithm, the selected child element indicating the ordering of the blocks;
    the method preferably further comprising, after the performing of the genetic algorithm using the subset:

updating the neural network based on a fitness value of a child element obtained from the subset through the genetic algorithm.

12. The method of the previous claim, wherein the generating of the subset by performing sampling using the neural network on the elements comprises:

determining a probability of an element in a population generated from a random selection of the elements, the probability determined using the neural network; and
generating the subset based on the probability.

13. The method of the previous claim, wherein the determined probability corresponds to a possibility that a child element generated from the element in the subset is determined to be an optimal solution of a problem being solved by the genetic algorithm; and/or
wherein the generating of the subset based on the probability comprises:
sampling an element with a probability greater than a predetermined magnitude or sampling a predetermined number of elements in order of probability from highest probability to lowest probability.

14. A method for generating a subset of a population for a genetic algorithm, the method performed by one or more processors, the method comprising:

determining scores of respective elements comprised in the population by using a neural network to infer the scores;
generating the subset comprising elements in the population based on the scores; and
updating the neural network based on a fitness value of a child element generated from the elements in the subset.

15. The method of the previous claim, wherein the updating of the neural network based on the fitness value of the child element generated comprises:

determining the fitness value of the child element for a problem to which the genetic algorithm is applied by performing a simulation on the child element; and
providing a reward to the neural network based on the fitness value of the child element.

# FIG. 1

| Neural network | — | Subset generator | — | Genetic algorithm (GA) processor |

100           200           300

# FIG. 2

Start

Generating population ——S110

Generating subset of population ——S120

Performing GA process
using element selected
from subset ——S130

Calculating fitness value
by performing simulation on K
child elements generated
through GA process ——S140

S150 — Whether fitness value of child element satisfies predetermined criteria ?

No

S160

Updating population based
on fitness value
of child element

Yes

Determining child element
that meets predetermined
criteria as answer to problem ——S170

End

# FIG. 3

Start

↓

| Artificial neural network calculates probability of each element | ~ S121 |

↓

| Subset generator generates subset based on probability of element | ~ S122 |

↓

| Artificial neural network is updated based on fitness value of child element output from generated subset | ~ S180 |

↓

End

# FIG. 4

State State Reward Action

100

Agent :
Artificial neural
network

Environment :
Population

# FIG. 5

Start

Selecting a pair of elements
from subset — S131

Performing crossover
for selected element — S132

Performing mutation
for selected element — S133

Performing local optimizing
for selected element — S134

Generating child element
from a pair of elements — S135

End

# FIG. 6

<u>600</u>

# FIG. 7

Processor — 710

Memory — 720

700

# FIG. 8

| Buffer | Buffer | Buffer | Buffer | Buffer | Buffer | Inverter | Inverter | AND | AND | AND | AND | OR |

$$[0,1,2,3,4,5,6,7,8,9,10,11,12]$$

Input

## Problem solving system

| Artificial neural network | Subset generator | GA processor |

100     200     300

Output

$$[0,2,12,8,9,3,4,11,6,7,1,10,5]$$

Europäisches
Patentamt

European
Patent Office

Office européen
des brevets

# EUROPEAN SEARCH REPORT

**Application Number**

EP 24 19 8874

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KOUROSH HAKHAMANESHI ET AL: "BagNet: Berkeley Analog Generator with Layout Optimizer Boosted with Deep Neural Networks", ARXIV.ORG, CORNELL UNIVERSITY LIBRARY, 201 OLIN LIBRARY CORNELL UNIVERSITY ITHACA, NY 14853, 23 July 2019 (2019-07-23), XP081447989, * abstract; sections 2.1, 2.2, 2.3, 2.4, 3.1 Algorithm 1, 2; figures 1,2 * | 1-15 | INV. G06N3/086 G06N3/092 |
| A | REN YANGMING ET AL: "Genetic-algorithm-based deep neural networks for highly efficient photonic device design", PHOTONICS RESEARCH, [Online] vol. 9, no. 6, 24 May 2021 (2021-05-24), page B247, XP093240231, US ISSN: 2327-9125, DOI: 10.1364/PRJ.416294 Retrieved from the Internet: URL:https://opg.optica.org/directpdfaccess/7026424a-bae9-4b24-820a276e2117fb68_451407/prj-9-6-b247.pdf?da=1&id=451407&seq=0&mobile=no> [retrieved on 2025-01-16] * abstract; sections 2,3; figures 1-4 * | 1-15 | |

TECHNICAL FIELDS SEARCHED (IPC)

G06N

-/--

The present search report has been drawn up for all claims

| Place of search | Date of completion of the search | Examiner |
|---|---|---|
| The Hague | 16 January 2025 | Tebbal Barracosa, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 24 19 8874

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SETTALURI KEERTANA ET AL: "AutoCkt: Deep Reinforcement Learning of Analog Circuit Designs", 2020 DESIGN, AUTOMATION & TEST IN EUROPE CONFERENCE & EXHIBITION (DATE), EDAA, 9 March 2020 (2020-03-09), pages 490-495, XP033781374, DOI: 10.23919/DATE48585.2020.9116200 [retrieved on 2020-06-12] * abstract; sections II, III; figure 1 * | 1-15 | |
| A | CHRISTOF ANGERMUELLER ET AL: "Population-Based Black-Box Optimization for Biological Sequence Design", ARXIV.ORG, CORNELL UNIVERSITY LIBRARY, 201 OLIN LIBRARY CORNELL UNIVERSITY ITHACA, NY 14853, 11 July 2020 (2020-07-11), XP081711750, DOI: 10.1111/J.1365-246X.2006.03227.X * abstract; section 3 Algorithms 1 and 2 * | 1-15 | **TECHNICAL FIELDS SEARCHED (IPC)** |

The present search report has been drawn up for all claims

| Place of search | Date of completion of the search | Examiner |
|---|---|---|
| The Hague | 16 January 2025 | Tebbal Barracosa, B |

EPO FORM 1503 03.82 (P04C01)